# FASCICULE DE BREVET EUROPEEN

(11) **EP 0 691 749 B1**
(45) Date de publication et mention de la délivrance du brevet: **07.04.1999**
(21) Numéro de dépôt: 95401515.2
(22) Date de dépôt: 26.06.1995
(51) Int. Cl.: H03M 1/24, G01D 5/34

(54) **Codeur numérique de position angulaire et son application notamment à un véhicule**
Digitaler Winkelgeber und dessen Anwendung in einem Kraftfahrzeug
Digital angular position encoder and its particular application in a vehicle

(30) Priorité: 05.07.1994 FR 9408298
(43) Date de publication de la demande: 10.01.1996
(73) Titulaire: ECIA - EQUIPEMENTS ET COMPOSANTS POUR L'INDUSTRIE AUTOMOBILE, F-25400 Audincourt (FR)
(72) Inventeur: Rudi, Alain, F-90850 Essert (FR); Marpaux, Emile Henri Roger, F-70400 Errevet (FR)
(74) Mandataire: Polus, Camille

(56) Documents cités:
- DE-A- 4 028 623
- PATENT ABSTRACTS OF JAPAN vol. 010 no. 147 (P-460) ,29 Mai 1986 & JP-A-61 000712 (TOUKIYOU SEIMITSU:KK) 6 Janvier 1986,

## Description

La présente invention concerne un codeur numérique de position angulaire destiné à être associé par exemple à un arbre pour en évaluer la rotation et l'application d'un tel codeur à un véhicule notamment automobile terrestre.

Dans de nombreux secteurs techniques, il est nécessaire d'évaluer la rotation d'un arbre ou similaire. Tel est le cas, par exemple, de l'industrie automobile pour laquelle on souhaite connaître la position ou l'évolution de la position d'un organe tournant ou basculant à bord d'un véhicule tel un volant ou une colonne de direction, un dossier de siège, des bras de suspension de roues. Il est toutefois clair qu'une telle application n'est pas limitative.

Quel que soit le type d'asservissement de position, le constituant essentiel dont la qualité de l'asservissement dépend toujours, est le capteur de recopie de position.

Sans parler des dispositifs très particuliers "self-syn", on utilise habituellement pour capteur un composant tel un potentiomètre analogique. Si le potentiomètre offre des avantages notoires en ce qui concerne la précision de la résolution et le fait qu'il délivre un signal aussitôt qu'il est électriquement alimenté, il présente aussi des inconvénients majeurs liés aux frottements mécaniques du curseur qui en abrègent la longévité tout spécialement lorsqu'un tel potentiomètre opère au voisinage d'une même position. En effet, dans ce cas notamment la piste se creuse ou les spires du bobinage se coupent par usure localisée.

Une autre technique, au lieu d'être analogique, est du type digital et fait appel à des codeurs qui délivrent des signaux séquentiels sous forme d'impulsions qui sont ensuite dénombrées et traitées par des calculateurs. Si les signaux sont créés à l'aide d'un potentiomètre, il faut insérer un convertisseur Analogique/Digital.

Le but de l'invention est de produire un codeur numérique de position angulaire qui délivre des groupes d'impulsions ou bits par exemple huit, qui forment un "mot" et sont directement assimilables par des calculateurs tels des microprocesseurs et qui sont produits optiquement pour les soustraire aux perturbations dues à l'usure ou aux parasites électromagnétiques.

L'invention a pour objet un codeur numérique de position angulaire destiné à être associé à un arbre ou similaire pour en évaluer la rotation. Ce codeur est remarquable en ce qu'il comprend un boîtier avec une paroi latérale, avec une embouchure et avec un fond et apte à porter au moins un palier pour recevoir l'arbre et définissant son axe de rotation, un support notamment avec une source lumineuse unique apte à émettre un faisceau lumineux principal et au moins un photorécepteur qui sont disposés radialement relativement à cet axe de rotation, un flasque avec un capteur aligné axialement avec cette source lumineuse pour en recevoir directement le faisceau lumineux principal, avec un diviseur optique pour recevoir le faisceau lumineux principal recueilli par le capteur et le diviser en pinceaux lumineux secondaires dont le nombre est égal à celui des photorécepteurs et donc chacun d'eux est apte à irradier un photorécepteur particulier correspondant, et un codeur optique digital placé entre ces support et flasque de manière à être interposé entre photorécepteurs et diviseur optique pour intercepter et moduler les flux lumineux des pinceaux secondaires et de manière à être porté par ce palier et à être apte à être calé en rotation sur l'arbre pour être entraîné par celui-ci.

L'invention a aussi pour objet l'application d'un codeur du type précédent à un véhicule notamment automobile terrestre.

D'autres caractéristiques et avantages de l'invention ressortiront de la lecture de la description et des revendications qui suivent, ainsi que de l'examen du dessin annexé, donné seulement à titre d'exemple où:
- la Figure 1 est une vue perspective schématique éclatée d'un mode de réalisation d'un codeur selon l'invention;

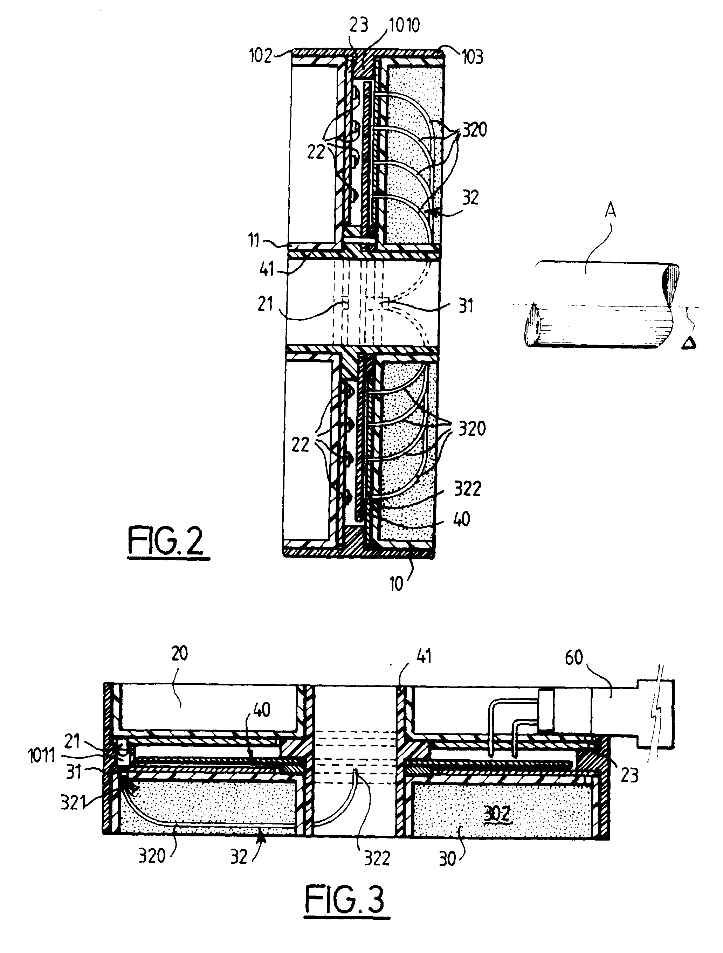

- les Figures 2 et 3 sont des coupes axiales schématiques selon deux méridiens pratiquement perpendiculaires, du mode de réalisation de la Figure 1 du codeur assemblé;
- la Figure 4 est une vue de détail partielle, à échelle plus grande, d'un constituant du mode de réalisation du codeur de la Figure 1; et
- les Figures 5A et 5B sont des vues recto-verso d'un autre constituant du mode de réalisation du codeur de la Figure 1.

Les codeurs numériques de position angulaire, et en particulier ceux utilisés habituellement à bord des véhicules automobiles terrestres étant bien connus dans la technique, on ne décrira dans ce qui suit que ce qui concerne directement ou indirectement l'invention. Pour le surplus, l'Homme du Métier du secteur technique considéré puisera dans les solutions classiques courantes à sa disposition pour faire face aux problèmes particuliers auxquels il est confronté.

Dans ce qui suit, on utilise toujours un même numéro de référence pour identifier un élément homologue, quel que soit le mode de réalisation ou sa variante d'exécution.

Pour la commodité de l'exposé, on décrira successivement chacun des constituants d'un codeur numérique de position angulaire selon l'invention, avant d'en exposer la fabrication au besoin, le montage et le fonctionnement.

Un codeur numérique de position angulaire selon l'invention comprend, essentiellement, un boîtier 10, un support 20, un flasque 30 et un codeur optique proprement dit 40. Un tel codeur comprend aussi des moyens de fixation 50 et un connecteur 60.

Le boîtier 10 est délimité par une paroi latérale 101, une embouchure 102 et un fond 103 ouvert ou fermé et est apte à porter au moins un palier 11 par exemple par l'entremise de ce fond, pour recevoir un arbre A afin d'en évaluer la rotation. Ce palier définit un axe de rotation Δ pour cet arbre. Comme on le voit, de préférence le boîtier présente une cloison 1010 intérieure annulaire périphérique, qui est transpercé d'un logement 1011 axial pour les raisons qui apparaîtront par la suite.

Le support 20 reçoit notamment une source lumineuse 21 unique telle que, par exemple, une ampoule miniature à incandescence ou une diode électroluminescente, ainsi qu'au moins un photorécepteur 22 tel une photodiode, un phototransistor, une photorésistance ou similaire. Ces source et photorécepteurs sont disposés radialement relativement à l'axe de rotation Δ. Comme on peut l'observer dans le mode de réalisation illustré, on utilise par exemple huit photorécepteurs qui sont organisés en deux groupes de quatre symétriques par rapport à l'axe et situés sur un même diamètre qui est pratiquement perpendiculaire à celui sur lequel est placée la source lumineuse. Le support 20 reçoit aussi, de préférence, un circuit électronique 23 avec tous ses composants et où sont situés la source lumineuse et les photorécepteurs. Ce circuit électronique par exemple sous forme de circuit imprimé, comprend tout ce qui est nécessaire à l'alimentation de la source lumineuse, des photorécepteurs et le cas échéant au traitement des signaux émis par les photorécepteurs comme on le comprendra par la suite. Ce support prend appui de préférence contre la cloison 1010.

Le flasque 30 est équipé d'un capteur 31 aligné axialement avec la source lumineuse 21 pour en recevoir directement le flux du faisceau lumineux principal et un diviseur optique 32 pour recevoir le faisceau lumineux principal recueilli par le capteur et le diviser en pinceaux lumineux secondaires dont le nombre est égal à celui des photorécepteurs et dont chacun d'eux est apte à irradier un photorécepteur particulier correspondant. Le diviseur optique 32 est, par exemple, constitué de fibres 320 optiques qui sont toutes disposées d'un même côté du codeur optique 40 et dont l'un des bouts de chacune d'elles sont réunis ensemble pour former une entrée 321 unique servant de capteurs 31 proprement dit, et dont l'autre des bouts de chacune d'elles sont séparés les uns des autres pour former des sorties 322 multiples distinctes, placées en vis-à-vis chacune d'un photorécepteur 22 particulier correspondant. Le flasque 30 se présente par exemple à la manière d'une cuvette 301 avec un socle 3010 transpercé d'un trou 3011 pour recevoir l'entrée unique commune 321 servant de capteur 31 et transpercé d'orifices 3012 destinés à recevoir chacun une des sorties multiples distinctes 322. Ce flasque prend appui de préférence contre la cloison 1010.

Les fibres optiques 320 sont par exemple maintenues en place à l'aide d'une résine 302 ou similaire par exemple synthétique, appropriée coulée dans la cuvette du flasque, dans laquelle elles sont noyées.

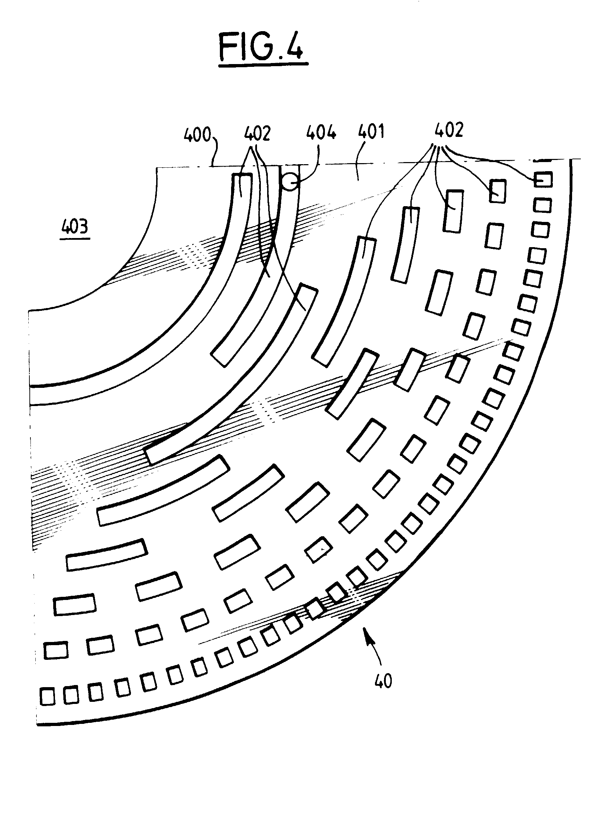

Le codeur optique digital 40 est placé entre ces support 20 et flasque 30 de manière à être interposé entre photorécepteurs 22 et diviseur optique 32 pour intercepter et moduler les flux des pinceaux lumineux secondaires et de manière à être porté par le palier 11 et à être apte à être calé en rotation sur l'arbre A pour être entraîné par celui-ci. Le codeur 40 se présente de préférence à la manière d'un disque 400 logé dans le boîtier et dont une surface 401 porte des plages 402 réparties selon des cercles concentriques de rayons propres différents. Cette surface 401 et ces plages 402 présentent des densités optiques propres différentes l'une de l'autre. Par exemple, la surface 401 est opaque et les plages 402 sont transparentes. Comme on peut l'observer notamment sur la Figure 4, de préférence, la taille de deux plages successives situées sur un même cercle de rayon déterminé est égale à l'intervalle qui les sépare. On observera aussi que la fréquence de ces plages situées par exemple sur huit cercles concentriques de rayons différents, est telle qu'elle double lorsqu'on passe d'un cercle au cercle de rayon plus grand immédiatement voisin. De préférence, le disque 400 est transpercé d'un passage 403 central et est muni d'un détrompeur ou analogue 404 tel un pied ou une encoche servant à son calage angulaire pour fixer une origine. Un manchon 41 est associé au disque pour servir de moyeu coopérant par exemple avec le palier et destiné à recevoir l'arbre sur lequel il est calé et immobilisé en rotation par toute technique appropriée classique par exemple clavetage, collage.... Ce manchon peut aussi être d'un seul tenant avec le disque et être venu de matière avec lui. Ce manchon sert de moyeu.

Des moyens de fixation 50 servent à l'assemblage les constituants du codeur numérique afin qu'ils forment une entité prête à être utilisée. Ces moyens de fixation 50 de tout type classique approprié sont par exemple des tiges filetées destinées à recevoir des écrous et des entretoises voire des nervures et languettes destinées à s'encastrer mutuellement par encliquetage élastique ou non,....

Un connecteur 60 par exemple à dix bornes tel que des broches et/ou des fiches assure les liaisons électriques. On utilise par exemple dix bornes parmi lesquelles deux d'entre elles servent à l'alimentation du circuit électronique et huit d'entre elles servent à acheminer les signaux émis par chacun des photorécepteurs.

Les boîtier, support et flasque sont faits en tout matériau classique traditionnel convenable pour l'application visée, qui est mis en forme selon des techniques appropriées. Ils sont faits par exemple à base de métal ou à base de résine synthétique. Le codeur optique proprement dit est fait par exemple d'un disque métallique dans lequel les plages sont découpées par électroérosion ou au laser ou bien d'une matière plastique telle que du méthacrylate sur lequel les plages sont obtenues par des techniques sérigraphiques ou photographiques du type de celles utilisées par exemple pour fabriquer des circuits imprimés. Le codeur optique proprement dit peut aussi être fait en une matière plastique moulée par injection.

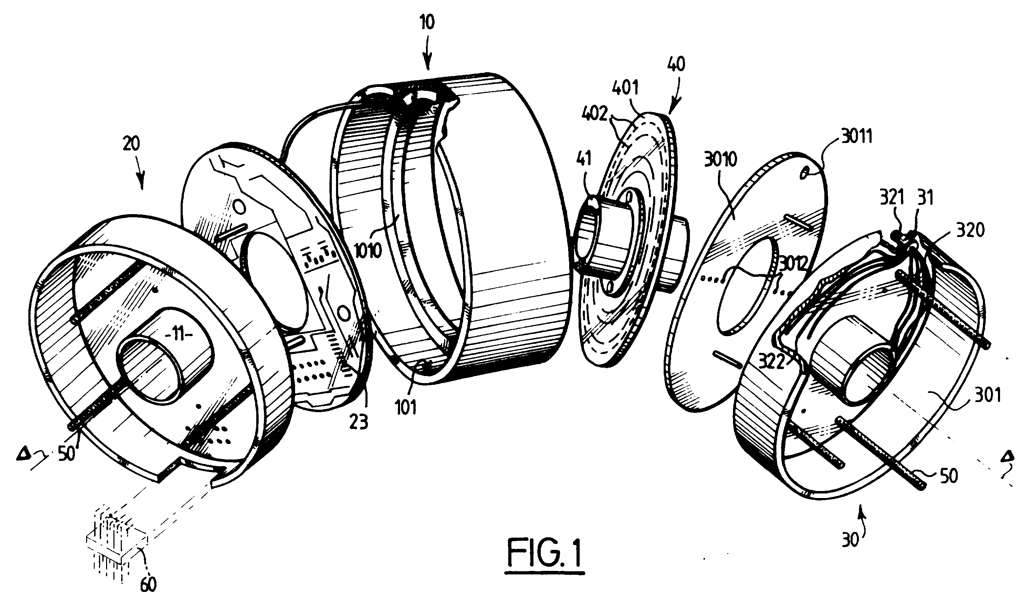

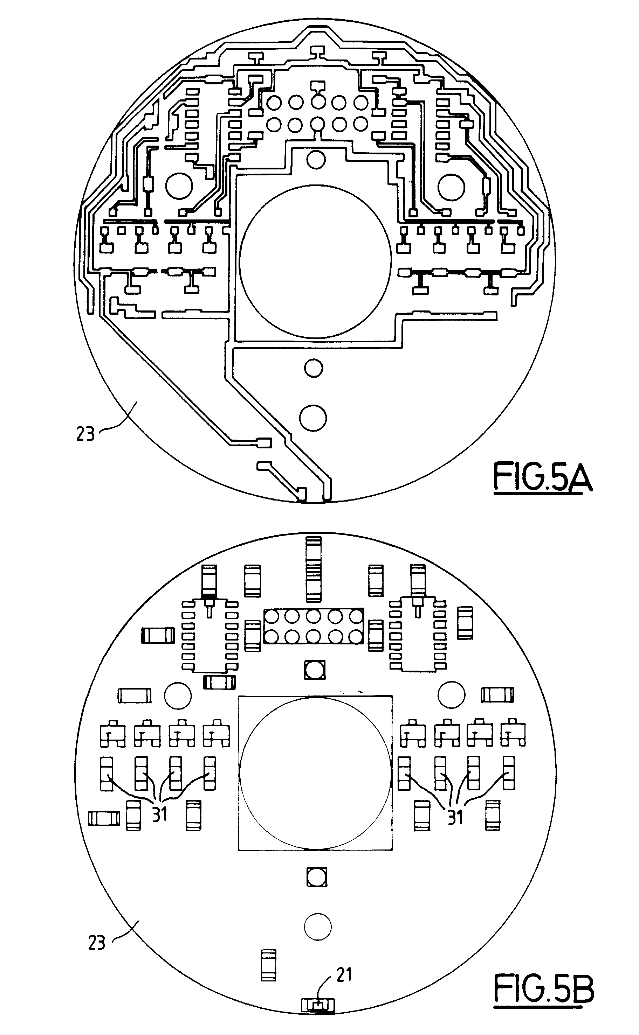

Tous les constituants d'un codeur numérique de position angulaire selon l'invention sont réunis, assemblés et montés comme cela ressort clairement de l'examen des figures du dessin. On observera toutefois que sur la Figure 1, par commodité pour l'illustration, on a supposé que la source lumineuse mise en place dans son logement axial était reliée par un cordon au circuit électronique. Il est clair qu'en pratique la source lumineuse est de préférence montée directement sur le circuit électronique comme dessiné sur la Figure 5B.

On comprend donc que lorsque le connecteur électrique est convenablement raccordé, la source lumineuse unique produit un faisceau principal dont le flux est recueilli directement par le capteur sans traversée du codeur optique puisque source et capteur sont situés à l'extérieur de celui-ci, comme décrit et illustré. Ce flux non modulé recueilli par le capteur est repris par le diviseur qui le partage en pinceaux secondaires dont le flux de chacun d'eux est modulé par la traversée du codeur optique avant d'irradier un photorécepteur particulier qui émet alors un signal propre sous forme de bit 0 ou 1 selon que ce flux d'un pinceau secondaire est arrêté par la surface ou transmis par une plage, par exemple.

Afin de s'affranchir de tout problème de centrage très précis, on utilise des fibres optiques dont le diamètre est nettement inférieur à la taille de chacune des plages ou fenêtres. En utilisant par exemple des fibres de 0,25 mm et des plages de 0,6 x 0,8 mm, on peut accepter un "faux rond" important.

A titre de composant électronique constituant les photorécepteurs, on utilise par exemple ceux qui figurent sous la référence HSE 100 sur le catalogue de la société HONEYWELL.

En utilisant un disque d'une cinquantaine de millimètres de diamètre avec huit cercles et qui est apte à délivrer des signaux de position sur un tour avec des mots de 8 bits, on peut produire 512 états, c'est-à-dire une résolution angulaire de l'ordre de 0,7°.

Un codeur selon l'invention a un encombrement en diamètre de l'ordre de 60 mm et une épaisseur de l'ordre de 18 mm et est apte à recevoir un arbre d'une douzaine de millimètres.

On voit donc que grâce à l'invention, du fait qu'on utilise une source lumineuse unique dont on divise le faisceau à l'aide de fibres optiques par exemple, on n'utilise qu'une seule carte électronique qui reçoit tous les composants et qui peut être fabriquée automatiquement sur des machines classiques prévues à cet effet.

Un codeur selon l'invention permet d'évaluer et/ou de mesurer des positions angulaires en valeur absolue ou en valeur relative tant en amplitude et sens qu'en vitesse ou accélération angulaire. Si l'on désire opérer sur plus d'un tour, il suffit d'organiser le codeur en spirale et/ou en hélice.

Il est clair que l'application décrite à propos du domaine de l'automobile n'a été donnée qu'à titre indicatif et qu'un codeur selon l'invention qui est d'un coût modique peut aussi servir par exemple pour des appareils domestiques par exemple électroménagers.

Selon l'usage auquel il est destiné, le codeur selon l'invention est équipé d'un palier unique ou multiple, lisse ou à roulement à billes ou similaire.

Ce qui précède met bien en lumière les particularités distinctives de l'invention, l'intérêt qu'elle offre et les avantages qu'elle apporte.

## Revendications

1. Codeur numérique de position angulaire destiné à être associé à un arbre (A) pour en évaluer la rotation selon un axe (Δ), codeur qui comprend un boîtier (10) avec une paroi (101) latérale, avec une embouchure (102) et avec un fond (103), un support (20) notamment avec une source (21) lumineuse unique apte à émettre un faisceau lumineux principal et au moins un photorécepteur (22) qui sont disposés radialement relativement à cet axe de rotation (Δ), un flasque (30) avec un capteur (31) aligné axialement avec cette source lumineuse (21) pour en recevoir le flux lumineux, avec un diviseur (32) optique pour recevoir directement le faisceau lumineux principal recueilli par le capteur (31) et le diviser en pinceaux lumineux secondaires dont le nombre est égal à celui des photorécepteurs (22) et dont chacun d'eux est apte à irradier un photorécepteur (22) particulier correspondant, et un codeur optique digital (40) placé entre ces support (20) et flasque (30) et qui est caractérisé en ce que le codeur optique digital (40) est placé de manière à être interposé entre, d'une part, ces source (21) et photorécepteurs (22) et, d'autre part, ce diviseur optique (32) pour intercepter et moduler les flux lumineux des pinceaux secondaires, en ce que le diviseur optique (32) est unique et situé d'un seul côté du codeur optique (40) et à l'opposé de ces source (21) et photorécepteurs (22), en ce que le boîtier (10) est apte à porter au moins un palier (11) pour recevoir l'arbre (A) et en définir l'axe de rotation (Δ), et en ce que le codeur optique (40) est apte à être porté par ce palier (11) et à être calé en rotation sur l'arbre (A) pour être entraîné par celui-ci.

2. Codeur selon la revendication 1, caractérisé en ce que le diviseur optique (32) est fait de fibres (320) optiques qui sont toutes disposées d'un même côté du codeur optique (40) et dont l'un des bouts de chacune d'elles sont réunis ensemble pour former une entrée (321) unique servant de capteur (31) et dont l'autre des bouts de chacune d'elles sont séparés les uns des autres pour former des sorties (322) multiples distinctes placées en vis-à-vis chacune d'un photorécepteur (22) particulier correspondant.

3. Codeur selon la revendication 2, caractérisé en ce que le flasque (30) a la configuration d'une cuvette (301) munie d'un socle (3010) avec un trou (3011) pour le capteur (31) et avec des orifices (3012) pour les sorties (322).

4. Codeur selon la revendication 2 ou 3, caractérisé en ce que les fibres (320) sont noyées dans une résine (302).

5. Codeur selon l'une quelconque des revendications 1 à 4, caractérisé en ce que le codeur optique digital (40) a la configuration d'un disque (400) dont la surface (401) porte des plages (402) réparties selon des cercles concentriques de rayons propres différents et en ce que cette surface (401) et ces plages (402) sont de densités optiques différentes.

6. Codeur selon la revendication 5, caractérisé en ce que pour chacun des cercles, ces plages (402) ont une taille et une fréquence angulaire déterminées.

7. Codeur selon la revendication 5 ou 6, caractérisé en ce que la surface (401) est opaque et les plages (402) sont transparentes.

8. Codeur selon l'une quelconque des revendications 5 à 7, caractérisé en ce que le disque (400) présente un passage (403) central.

9. Codeur selon l'une quelconque des revendications 5 à 8, caractérisé en ce que le codeur optique digital (40) est pourvu d'un manchon (41) central apte à coopérer avec le palier (11) voire avec l'arbre (A) pour servir de moyeu.

10. Codeur selon l'une quelconque des revendications 1 à 9, caractérisé en ce que le support (20) porte un circuit électronique (23) relié à la source lumineuse (21) et aux photorécepteurs (22).

11. Codeur selon l'une quelconque des revendications 1 à 10, caractérisé en ce que la paroi latérale (101) du boîtier (10) est munie d'une cloison (1010) intérieure annulaire périphérique.

12. Codeur selon la revendication 11, caractérisé en ce que cette cloison (1010) est transpercée d'un logement (1011) axial qui est situé à l'écart du codeur (40) et qui est destiné à recevoir la source lumineuse (21).

13. Codeur selon la revendication 11 ou 12, caractérisé en ce que cette cloison (1010) sert d'appui à l'un au moins de ces support (20) et flasque (30).

14. Application d'un codeur conforme à l'une quelconque des revendications précédentes à un véhicule notamment automobile terrestre.

## Claims

1. Numerical angular position encoder intended to be associated with a shaft (A) for evaluating its rotation about an axis (Δ), this encoder comprising a case (10) with a lateral wall (101), with an opening (102), with a bottom (103), a support (20) and in particular with a unique light source (21) capable of emitting a main light beam and at least one photo-receiver (22) which are disposed radially with respect to this axis of rotation (Δ), a flange (30) with a sensor (31) aligned axially with this light source (21) in order to receive the light flux from it, with an optical divider (32) for receiving directly the main light beam picked up by the sensor (31) and dividing it up into secondary pencils of light whose number is equal to that of the photo-receivers (22) and each of which is capable of irradiating a corresponding individual photo-receiver (22), and an digital optical encoder (40) placed between this support (20) and this flange (30) and which is characterised in that the digital optical encoder (40) is placed in such a way as to be interposed between, on the one hand, this source (21) and these photo-receivers (22) and, on the other hand, this optical divider (32) in order to intercept and modulate the light fluxes of the secondary pencils, and in that the optical divider (32) is unique and situated on only one side of the optical encoder (40) and opposite to this source (21) and these photo-receivers (22), and in that the case (10) is capable of carrying at least one bearing (11) for receiving the shaft (A) and for defining its axis of rotation (Δ), and in that the optical encoder (40) is capable of being carried by this bearing (11) and of being locked in rotation on the shaft (A) in order to be driven by the latter.

2. Encoder according to Claim 1, characterised in that the optical divider (32) is made of optical fibres (320) which are all disposed on the same side of the optical encoder (40) and one of ends of each of them are joined together in order to form a single input (321) serving as a sensor (31) and the other ends of each of them are separated from one another in order to form separate multiple outputs (322) each of them facing an individual corresponding photo-receiver (22).

3. Encoder according to Claim 2, characterised in that the flange (30) has the configuration of a cup (301) provided with a base (3010) with a hole (3011) for the sensor (31) and with orifices (3012) for the outputs (322).

4. Encoder according to Claim 2 or 3, characterised in that the fibres (320) are embedded in a resin (302).

5. Encoder according to any one of Claims 1 to 4, characterised in that the optical encoder (40) has the configuration of a disk (400) whose surface (401) carries fields (402) distributed in concentric circles each with their own different radius (401) and these fields (402) are of different optical density.

6. Encoder according to Claim 5, characterised in that, for each of the circles, these fields (402) have a specified size and angular frequency.

7. Encoder cording to Claim 5 or 6, characterised in that the surface (401) is opaque and the fields (402) are transparent.

8. Encoder according to any one of Claims 5 to 7, characterised in that the disk (400) has a central passage (403).

9. Encoder according to any one of Claims 5 to 8, characterised in that the digital optical encoder (40) is provided with a central bush (41) designed to co-operate with the bearing (11) or even with the shaft (A) to serve as a hub.

10. Encoder according to any one of Claims 1 to 9, characterised in that the support (20) carries an electronic circuit (23) connected to the light source (21) and to the photo-receivers (22).

11. Encoder according to any one of Claims 1 to 10, characterised in that the lateral wall (101) of the case (10) is provided with an inner peripheral annular partition (1010).

12. Encoder according to Claim 11 , characterised in that this partition (1010) is transpierced with an axial housing (1011) which is situated to the side of the encoder (40) and which is intended to receive the light source (21).

13. Encoder according to Claim 11 or 12, characterised in that this partition (1010) is used as a support for at least one of the said support (20) and the said flange (30).

14. Application of an encoder according to any one of the preceding claims to a vehicle and to a motor vehicle in particular.

## Patentansprüche

1. Digitaler Winkelgeber, der dazu bestimmt ist, mit einer Welle (A) verbunden zu werden, um deren Drehung um eine Achse (A) zu bestimmen, wobei der Winkelgeber ein Gehäuse (10) mit einer Seitenwandung (101), mit einer Öffnung (102) und mit einem Boden (103) aufweist sowie eine Stütze (20), insbesondere mit einer einzigen Lichtquelle (21), die geeignet ist, ein Hauptlichtbündel auszusenden, und mindestens einem Photorezeptor (22), die radial in bezug zu dieser Drehachse (Δ) angeordnet sind, einen Flansch (30) mit einem Sensor (31), der axial mit dieser Lichtquelle (21) ausgerichtet ist, um von ihr den Lichtstrom aufzunehmen, und mit einem optischen Teiler (32), um direkt das Hauptlichtbündel aufzunehmen, das von dem Sensor (31) empfangen wurde, und es in Unterlichtbündel zu teilen, deren Anzahl gleich jener der Photorezeptoren (22) ist und von denen jedes in der Lage ist, einen besonderen, entsprechenden Photorezeptor (22) zu bestrahlen, und einen digitalen optischen Kodierer (40), der zwischen der Stütze (20) und dem Flansch (30) angeordnet ist, dadurch gekennzeichnet, daß der digitale optische Kodierer (40) derart angeordnet ist, daß er einerseits zwischen der Quelle (21) und den Photorezeptoren (22) und andererseits dem optischen Teiler (32) positioniert ist, um den Lichtstrom der Unterbündel aufzufangen und zu modulieren, daß nur ein optischer Teiler (32) vorhanden ist, der auf nur einer Seite des optischen Kodierers (40) und gegenüber der Quelle (21) und den Photorezeptoren (22) angeordnet ist, daß das Gehäuse (10) geeignet ist, mindestens ein Lager (11) zu tragen, um die Welle (A) aufzunehmen und damit die Drehachse (Δ) zu definieren, und daß der optische Kodierer (40) geeignet ist, von diesem Lager (11) getragen zu werden und während der Drehung auf der welle (A) befestigt zu sein, um von dieser angetrieben zu werden.

2. Winkelgeber nach Anspruch 1, dadurch gekennzeichnet, daß der optische Teiler (32) aus optischen Fasern (320) besteht, die alle auf einer selben Seite des optischen Kodierers (40) angeordnet sind, und die an jeweils einem Ende alle zusammengefaßt sind, um einen einzigen Eingang (321) zu bilden, der als Sensor (31) dient, und deren andere Enden jeder von ihnen voneinander getrennt sind, um zahlreiche unterschiedliche Ausgänge (322) zu bilden, von denen jeder gegenüber einem besonderen entsprechenden Photorezeptor (22) angeordnet ist.

3. Winkelgeber nach Anspruch 2, dadurch gekennzeichnet, daß der Flansch (30) die Ausfuhrung einer Wanne (301) aufweist, die mit einem Sockel (3010) mit einem Loch (3011) für den Sensor (31) und mit Öffnungen (3012) für die Ausgänge (322) versehen ist.

4. Winkelgeber nach Anspruch 2 oder 3, dadurch gekennzeichnet, daß die Fasern (320) in ein Harz (302) eingelassen sind.

5. Winkelgeber nach einem der Ansprüche 1 bis 4, dadurch gekennzeichnet, daß der digitale optische Kodierer (40) die Ausführung einer Scheibe (400) aufweist, deren Oberfläche (401) Bereiche (402) trägt, die in konzentrischen Kreisen mit unterschiedlichen eigenen Radien verteilt sind, und daß diese Oberfläche (401) und diese Bereiche (402) unterschiedliche optische Dichten aufweisen.

6. Winkelgeber nach Anspruch 5, dadurch gekennzeichnet, daß für jeden der Kreise diese Bereiche (402) eine bestimmte Größe und Winkel frequenz aufweisen.

7. Winkelgeber nach Anspruch 5 oder 6, dadurch gekennzeichnet, daß die Oberfläche (401) undurchsichtig ist und die Bereiche (402) transparent sind.

8. Winkelgeber nach einem der Ansprüche 5 bis 7, dadurch gekennzeichnet, daß die Scheibe (400) einen Mitteldurchgang (403) aufweist.

9. Winkelgeber nach einem der Ansprüche 5 bis 8, dadurch gekennzeichnet, daß der digitale optische Kodierer (40) mit einer Mittelmuffe (41) versehen ist, die geeignet ist, mit dem Lager (11) bzw. mit der Welle (A) zusammenzuwirken, um als Nabe zu dienen.

10. Winkelgeber nach einem der Ansprüche 1 bis 9, dadurch gekennzeichnet, daß die Stütze (20) eine elektronische Schaltung (23) trägt, die mit der Lichtquelle (21) und den Photorezeptoren (22) verbunden ist.

11. Winkelgeber nach einem der Ansprüche 1 bis 10, dadurch gekennzeichnet, daß die Seitenwandung (101) des Gehäuses (10) mit einer inneren ringförmigen Umfangstrennwand (1010) verbunden ist.

12. Winkelgeber nach Anspruch 11, dadurch gekennzeichnet, daß in diese Trennwand (1010) eine axiale Lagerung (1011) eingebracht ist, die sich in einer Entfernung von dem Kodierer (40) befindet und dazu bestimmt ist, die Lichtquelle (21) aufzunehmen.

13. Winkelgeber nach Anspruch 11 oder 12, dadurch gekennzeichnet, daß diese Trennwand (1010) als Auflager für mindestens einen von Stütze (20) und Flansch (30) dient.

14. Verwendung eines Winkelgebers nach einem der vorhergehenden Ansprüche bei einem Kraftfahrzeug, insbesondere bei einem Landkraftfahrzeug.
